Europäisches Patentamt

European Patent Office

Office européen des brevets

(11) Veröffentlichungsnummer: **0 052 256**
**B1**

# (12) EUROPÄISCHE PATENTSCHRIFT

(45) Veröffentlichungstag der Patentschrift:
12.03.86

(21) Anmeldenummer: 81108720.4

(22) Anmeldetag: 22.10.81

(51) Int. Cl.⁴: **G 01 R 21/00, H 03 H 11/16**

(54) Elektronische Einrichtung zur Erfassung der Blindleistung und Verwendung dieser Einrichtung.

(30) Priorität: 17.11.80 DE 3043303

(43) Veröffentlichungstag der Anmeldung:
26.05.82 Patentblatt 82/21

(45) Bekanntmachung des Hinweises auf die Patenterteilung:
12.03.86 Patentblatt 86/11

(84) Benannte Vertragsstaaten:
AT CH DE FR GB IT LI

(56) Entgegenhaltungen:
DE - A - 2 032 781
DE - A - 2 063 105
DE - A - 2 747 385
DE - B - 2 731 658
US - A - 3 286 178

Elektronik Lexikon 1974 Frankh'sche
Verlagshandlung-Stuttgart, Seite 20
ELEKTRONIK, Band 28, Nr. 8 19. April 1979 München D.
DÖPFER "Spannungsgesteuerter Phasenschieber"
Seite 98
IEEE TRANSACTIONS ON INSTRUMENTATION AND
MEASUREMENT, Band IM-24, Nr. 1 März 1975 T.S.
RATHORE "New All-Pass Phase-Shifter Configurations"
Seiten 83 bis 84

(73) Patentinhaber: Siemens Aktiengesellschaft, Berlin und
München Wittelsbacherplatz 2, D-8000 München 2 (DE)

(72) Erfinder: Schwendtner, Manfred, Dipl.-Ing.,
St.-Gundekar-Strasse 3, D-8501 Schwarzenbruck (DE)
Erfinder: Steinmüller, Günter, Laufamholzstrasse 65,
D-8500 Nürnberg (DE)

(56) Entgegenhaltungen: (Fortsetzung)
Die Akte enthält technische Angaben, die nach dem
Eingang der Anmeldung eingereicht wurden und die
nicht in dieser Patentschrift enthalten sind.

**Beschreibung**

Die Erfindung betrifft eine elektronische Einrichtung zur Erfassung der Blindleistung, bestehend aus zwei zum Anschluss an ein elektrisches Netz vorgesehenen Wandlern, die ausgangsseitig dem Netzstrom bzw. der Netzspannung proportionale Messspannungen liefert, aus einem Multiplizierglied mit zwei Eingängen zur Verarbeitung der beiden Messspannungen, das ausgangsseitig ein blindleistungsproportionales Signal liefert, wobei beiden Eingängen des Multipliziergliedes je ein Phasendrehglied vorgeschaltet ist, wobei bei der Nennfrequenz des Netzes das erste Phasenglied eine Phasendrehung von +45° und das zweite eine Phasendrehung von −45° erzeugt und die Verwendung dieser Einrichtung.

Im Handel sind Blindleistungsmessgeräte für Wechselspannung erhältlich, bei denen als Phasendrehglied zur Erzeugung einer Phasendrehung von 90° dem einen Eingang des Multipliziergliedes ein RC-Glied vorgeschaltet ist. Dies führt jedoch bei Frequenzänderungen im Netz zu einer nicht unerheblichen Verfälschung der Amplitude der das Phasendrehglied passierenden Messspannung sowie zu einer von 90° abweichenden Phasendrehung, da diese Phasendrehglieder sowohl eine frequenzabhängige Dämpfung als auch eine frequenzabhängige Phasenverschiebung aufweisen. Damit tritt bei Frequenzänderungen im Wechselspannungsnetz ein erhöhter, frequenzabhängiger Messfehler auf.

Eine Verringerung des Messfehlers wird mit einer Einrichtung der eingangs genannten Art, wie sie aus der DE-A-2 063 105 bekannt ist, erreicht. Hierbei wird die Drehung um 90° realisiert, indem eine Messgrösse um +45° und die andere Messgrösse um −45° phasenverschoben wird. Die Drehung um +45° wird mit einem rationalen Glied mit verzögert differenzierendem Verhalten, einem sogenannten «VD-Glied» erreicht. Die Phasenverschiebung um −45° wird mit einem Verzögerungsglied erster Ordnung oder einem PI-Glied verwirklicht. Auch hierbei bleibt aber die Schwierigkeit, dass diese Phasendrehglieder eine frequenzabhängige Dämpfung aufweisen. Auch hierbei tritt also bei Frequenzänderungen im Wechselspannungsnetz ein − wenn auch geringerer − frequenzabhängiger Messfehler auf.

Beispielsweise aus dem von W. Baier herausgegeben «Elektroniklexikon», 1974, Franckh'sche Verlagshandlung Stuttgart, Seite 20, ist die Existenz eines Allpasses bekannt. Ein solcher Allpass stellt einen elektrischen Vierpol dar, dessen Dämpfungscharakteristik in weiten Grenzen frequenzunabhängig ist, d.h., dass Frequenzänderungen keinen Amplitudenfehler verursachen, bei dem allerdings die hervorgerufene Phasendrehung frequenzabhängig ist. In der Veröffentlichung «Spannungsgesteuerter Phasenschieber» in «Elektronik», Band 28, Nr. 8, 1979, Seite 98, wird eine phasenschiebende Schaltung beschrieben, die einen Allpass darstellt.

Der Erfindung liegt die Aufgabe zugrunde, eine Einrichtung der eingangs genannten Art anzugeben, bei der der Messfehler auch beim Auftreten von Frequenzänderungen im speisenden Netz im wesentlichen konstant bleibt und weiter verringert ist.

Diese Aufgabe wird erfindungsgemäss dadurch gelöst, dass jedes Phasendrehglied als Allpass ausgeführt ist und dass das erste Phasendrehglied eine Übertragungsfunktion

$$\frac{1 - jfk1}{1 + jfk1}$$

und das zweite Phasendrehglied eine Übertragungsfunktion

$$\frac{1 - jfk2}{1 + jfk2}$$

aufweist, wobei k1 und k2 jeweils von den Phasendrehgliedern abhängige Konstanten sind und f die Netzfrequenz ist. Durch die Wirkung der beiden Allpässe wird − wie gewünscht − zwischen den beiden zu multiplizierenden Messspannungen eine Phasendrehung von 90° erzeugt. Da beide Allpässe im Bereich möglicher Frequenzänderungen keine frequenzabhängige Amplitudenänderung hervorrufen, tritt eine Verfälschung der Amplitude durch die Allpässe nicht auf. Allerdings weisen beide Allpässe im Bereich der Nennfrequenz des speisenden Netzes eine frequenzabhängige Phasendrehung auf; diese Frequenzabhängigkeit ist jedoch so geartet, dass eine Abnahme des Absolutwertes der durch einen Allpass hervorgerufenen Phasendrehung durch eine Zunahme des Absolutwertes der durch den anderen Allpass hervorgerufenen Phasendrehung nahezu vollkommen kompensiert wird. In einer grafischen Darstellung der durch die beiden Allpässe hervorgerufenen Phasendrehung in Abhängigkeit von der Frequenz verlaufen also die den beiden Allpässen zugehörigen Kurvenzüge in der Umgebung der Nennfrequenz in gleichem Abstand zueinander. Damit schliesst die erfindungsgemässe Einrichtung neben der Vermeidung eines Amplitudenfehlers auch einen Winkelfehler weitgehend aus, da die Winkeldifferenz trotz Frequenzabhängigkeit der Phasendrehung beider Allpässe zumindest in einem Bereich um die Nennfrequenz immer 90° beträgt. Ein weiterer Vorteil liegt darin, dass die Winkeldifferenz von 90° auch dann erhalten bleibt, wenn die elektrischen Eigenschaften der Bauelemente der beiden Allpässe, beispielsweise aufgrund von Alterungen oder Änderungen der Umgebungstemperatur, sich gleichartig ändern. Wie die beiden Allpässe auf die beiden Eingänge des Multipliziergliedes verteilt sind, ist grundsätzlich gleichgültig. Eine Vertauschung des bei Nennfrequenz eine Phasendrehung von $\varphi_2 = +45°$ hervorrufenden Allpasses mit dem bei Nennfrequenz eine Phasendrehung von $\varphi^1 = -45°$ erzeugenden Allpasses bewirkt am Ausgang des Multipliziergliedes lediglich eine Umkehr des Vorzeichens des blindleistungsproportionalen Signals.

Eine bevorzugte Ausführungsform der Erfindung besteht darin, dass die Eingangsklemme des eine Phasendrehung von $\varphi_1 = -45°$ bewirkenden Allpasses über einen Widerstand mit dem invertierenden Eingang eines Operationsverstärkers verbunden ist, dessen an die Ausgangsklemme angeschlossener Ausgang über einen Widerstand gleicher Grösse ebenfalls mit dem invertierenden Eingang verbunden ist, dass die Eingangsklemme ferner über einen weiteren Widerstand an den nichtinvertierenden Eingang des Operationsverstärkers angeschlossen ist, der zugleich über einen Kondensator mit dem Bezugspotential verbunden ist, wobei für den Widerstandswert R des weiteren Widerstandes und die Kapazität C des Kondensators die Beziehung $\varphi_1 = -2 \cdot \arctan (2\pi f_0 CR)$ gilt ($f_0$: Nennfrequenz des Netzes). Ein derartiger Allpass für eine Phasendrehung von $\varphi_1 = -45°$ ist mit geringem Kostenaufwand aus handelsüblichen Bauelementen herstellbar.

Eine weitere bevorzugte Ausführungsform besteht darin, dass die Eingangsklemme des eine Phasendrehung von $\varphi_2 = +45°$ bewirkenden Allpasses über einen Widerstand mit dem invertierenden Eingang eines Operationsverstärkers verbunden ist, dessen an die Ausgangsklemme angeschlossener Ausgang über einen Widerstand gleicher Grösse ebenfalls mit dem invertierenden Eingang verbunden ist, dass die Eingangsklemme ferner über einen Kondensator an den nichtinvertierenden Eingang des Operationsverstärkers angeschlossen ist, der zugleich über einen weiteren Widerstand mit dem Bezugspotential verbunden ist, wobei für den Widerstandswert R des weiteren Widerstandes und die Kapazität C des Kondensators die Beziehung $\varphi_2 = 2 \arctan 1/(2\pi f_0 CR)$ gilt ($f_0$: Nennfrequenz des Netzes).

Die erfindungsgemässe Einrichtung kann als Komponente eines Blindverbrauchszählers Verwendung finden, wobei das ausgangsseitige blindleistungsproportionale Signal des Multipliziergliedes über einen Quantisierer einem integrierenden Zählwerk mit Anzeige zugeführt ist. Damit entsteht ein Blindverbrauchszähler, dessen Messfehler nahezu frequenzunabhängig ist.

Die erfindungsgemässe Einrichtung kann ferner zur Erfassung der Blindleistung in einem Drehstromsystem verwendet werden, wobei jeder Phase des Drehstromsystems eine solche Einrichtung zugeordnet ist und die ausgangsseitigen blindleistungsproportionalen Signale der Multiplizierglieder in einem Summierglied addiert sind.

Die erfindungsgemässe Einrichtung kann ferner vorteilhaft als Komponente eines Drehstrom-Blindverbrauchszählers Verwendung finden, wobei jeder Phase des Drehstromsystems eine solche Einrichtung zugeordnet ist und die ausgangsseitigen blindleistungspoportionalen Signale der Multiplizierglieder in einem Summierglied addiert sind und das Ausgangssignal des Summiergliedes über einen Quantisierer einem integrierenden Zählwerk mit Anzeige zugeführt ist. Ein derartiger Drehstrom-Blindverbrauchszähler weist nahezu keinen frequenzabhängigen Messfehler mehr auf.

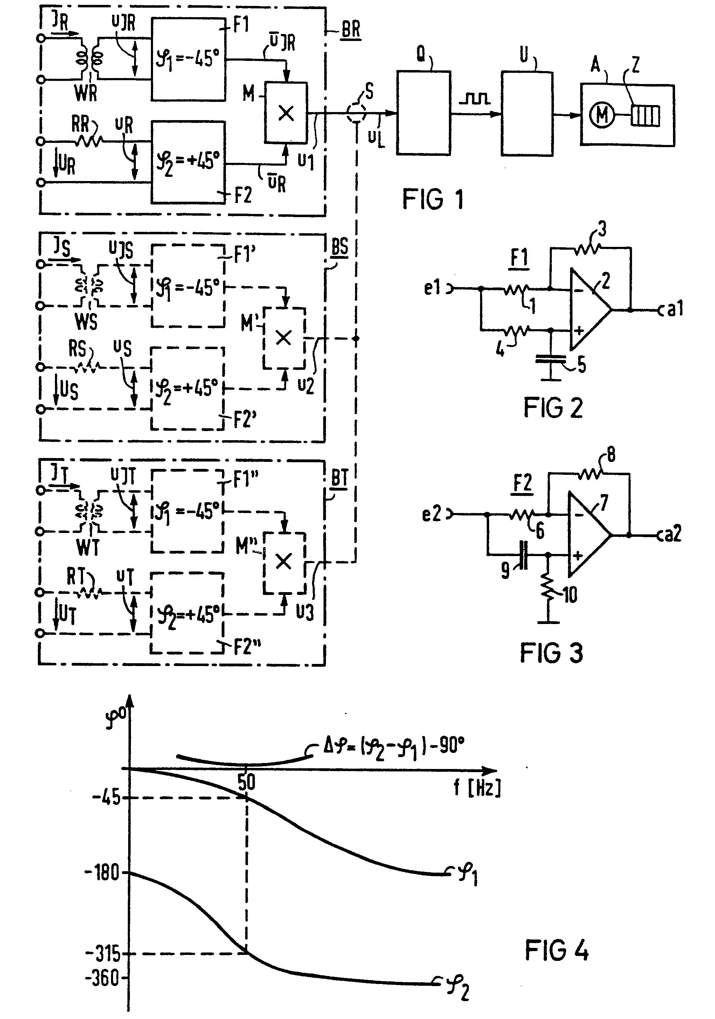

Die Erfindung wird im folgenden anhand eines Ausführungsbeispiels in den Fig. 1 bis 4 näher erläutert.

Im oberen Teil der Fig. 1 ist in dem mit BR bezeichneten Block eine elektronische Einrichtung zur Erfassung der Blindleistung in einem Wechselspannungsnetz dargestellt. Die Wechselspannung entspricht hierbei der Phase R eines Drehstromnetzes. Zur Erfassung des Netzstromes $I_R$ dient ein Wandler WR, der ausgangsseitig eine dem Netzstrom proportionale Messspannung $u_{IR}$ am Eingangswiderstand des bei Nennfrequenz der Wechselspannung eine Phasendrehung von $\varphi_1 = -450°$ erzeugenden Allpasses F1 zur Verfügung stellt. Der Wandler WR kann auch als Stromwandler mit eigenem Bürdenwiderstand ausgebildet sein. Als Wandler zur Erfassung der Netzspannung $U_R$ dient ein Vorwiderstand RR, über den der bei Nennfrequenz der Wechselspannung eine Phasendrehung von $\varphi_2 = +45°$ hervorrufenden Allpass F2 ans Netz angeschlossen ist. Am Eingangswiderstand dieses Allpasses F2 entsteht somit die der Netzspannung $U_R$ proportionale Messspannung $u_R$. Der Eingangswiderstand des Allpasses F2 bildet mit dem Vorwiderstand RR einen als Spannungswandler eingesetzten Spannungsteiler. Stattdessen kann auch ein konventioneller, auf dem Induktionsprinzip beruhender Spannungswandler eingesetzt sein. Am Ausgang der beiden Allpässe F1 und F2 treten die beiden Messspannungen $\bar{u}_{IR}$ und $\bar{u}_R$ auf, wobei bei Nennfrequenz erstere um $-45°$ gegenüber der eingangsseitigen Messspannung $u_{IR}$, letztere um $+45°$ gegenüber der eingangsseitigen Messspannung $U_R$ phasenverschoben ist. Durch die beiden Allpässe F1 und F2 erfahren also die beiden dem Netzstrom und der Netzspannung proportionalen Messspannungen $u_{IR}$ und $u_R$ eine relative Phasendrehung von 90°. Die phasenverschobenen Messspannungen $\bar{u}_{IR}$ und $\bar{u}_R$ werden den Eingängen eines elektronischen Multipliziergliedes M zugeführt. Das elektronische Multiplizierglied kann beispielsweise als Time-Division-Multiplizierer ausgeführt sein. Solche Time-Division-Multiplizierer sind beispielsweise aus der Zeitschrift «Technisches Messen atm», 1978, Heft 11, Seite 408 oder DE-A-2 747 385 bekannt. Am Ausgang des Multipliziergliedes M steht ein Signal u1 an, dessen Gleichspannungsmittelwert proportional zu dem Produkt $U_R \cdot I_R \cdot \sin\varphi$, d.h. proportional zur Blindleistung des angeschlossenen Verbrauchers ist.

Die im Block BR enthaltene Blindleistungserfassungseinrichtung kann als Komponente eines Blindverbrauchszählers genutzt werden. Zu diesem Zweck wird das Ausgangssignal u1 des Multiplizierers M einem Quantisierer Q zugeführt. Der Quantisierer liefert ausgangsseitig einen Impulszug, dessen Frequenz proportional zur erfassten Blindleistung ist. Solche Quantisierer Q sind ebenfalls aus den vorerwähnten Literaturstellen «Technisches Messen atm», 1978, Heft 11, Seiten 408 bis 410 oder der DE-A-2 747 385 bekannt. Dieser Impulszug wird zur Frequenzherabsetzung über einen Frequenzteiler U einem integrierenden Zählwerk mit Anzeige A zugeführt, das beispielsweise einen Schrittmotor M und ein von diesem Motor angetriebenes Rollenzählwerk Z aufweisen kann.

Um die Blindleistung in einem Drehstromnetz mit den Netzphasen R, S und T zu erfassen, ist jeder dieser Phasen ein mit dem im vorstehenden beschriebenen Block BR baugleicher Block zuzuordnen. Dies ist in Fig. 1 ebenfalls dargestellt. Zusätzlich zu dem Block BR sind hierbei die den Netzphasen S und T zugeordneten Blöcke BS und BT gestrichelt eingezeichnet. In diesem Fall ist es allerdings erforderlich, die Ausgangssignale u1, u2 und u3 der Multiplizierglieder M, M′ und M″ in einem Summenpunkt S zum Summensignal $u_L$ zu addieren. Der Gleichspannungsmittelwert des Summensignals $u_L$ ist proportional zu der dem Drehstromsystem entnommenen Blindleistung.

Um einen Drehstrom-Blindverbrauchszähler aufzubauen, ist es lediglich erforderlich, nunmehr das Summensignal $u_L$ über den Quantisierer Q und den Frequenzteiler U auf das integrierende Zählwerk mit Anzeige A zu führen.

In Fig. 2 ist ein Ausführungsbeispiel eines Allpasses F1 dargestellt, mit dem eine Phasendrehung von $\varphi_1 = -45°$ erzeugt werden kann. Hierbei ist die Eingangsklemme e1 über einen Widerstand 1 mit dem invertierenden Eingang eines Operationsverstärkers 2 verbunden. Der Ausgang dieses Operationsverstärkers 2 ist mit der Ausgangsklemme a1 des Allpasses F1 verbunden. Das Ausgangssignal des Operationsverstärkers 2 ist über einen Widerstand 3 auf den invertierenden Eingang zurückgeführt. Die Widerstände 1 und 3 weisen gleiche Widerstandswerte auf. Die Eingangsklemme·e1 ist ferner über einen weiteren Widerstand 4 an den nichtinvertierenden Eingang des Operationsverstärkers 2 angeschlossen, der über einen Kondensator 5 mit dem Bezugspotential verbunden ist. Für die Bemessung des weiteren Widerstandes 4 und des Kondensators 5 gilt die Beziehung $\varphi_1 = -45° = -2 \cdot arctan\ (2\pi f_0 CR)$. In einem Bemessungsbeispiel für eine Nennfrequenz des Netzes von $f_0 = 50$ Hz ergaben sich folgende Werte:

Widerstand 1: 56 kOhm
Widerstand 3: 56 kOhm
Widerstand 4: 59,9 kOhm
Kondensator 5: 22 nF

In Fig. 3 ist ein Ausführungsbeispiel für einen Allpass F2 dargestellt, mit dem eine Phasendrehung von $\varphi_2 = +45°$ bewirkt werden kann. Die Eingangsklemme e2 ist hierbei über einen Widerstand 6 mit dem invertierenden Eingang eines Operationsverstärkers 7 verbunden, dessen Ausgangsklemme mit der Ausgangsklemme a2 des Allpasses in Verbindung steht. Das Ausgangssignal des Operationsverstärkers 7 ist über einen Widerstand 8 auf den invertierenden Eingang zurückgeführt. Die Eingangsklemme e2 ist ferner über einen Kondensator 9 an den nichtinvertierenden Eingang des Operationsverstärkers 7 angeschlossen, der über einen weiteren Widerstand 10 mit dem Bezugspotential verbunden ist. Für die Bemessung des Kondensators 9 und des weiteren Widerstandes 10 gilt die Beziehung

$\varphi_2 = +45° = 2 \cdot arctan\ 1/(2\pi\ f_0 CR)$. Im Rahmen eines Bemessungsbeispiels für eine Nennfrequenz des Netzes von $f_0 = 50$ Hz ergaben sich dabei folgende Werte:

Widerstand 6: 56 kOhm
Widerstand 8: 56 kOhm
Kondensator 9: 100 nF
Widerstand 10: 76,8 kOhm

In Fig. 4 schliesslich ist qualitativ als Funktion der Frequenz des speisenden Netzes die Phasendrehung $\varphi_1$ des bei einer Nennfrequenz $f_0$ von 50 Hz exakt eine Phasendrehung von $-45°$ bewirkenden Allpasses F1, die Phasendrehung $\varphi_2$ des bei einer Nennfrequenz $f_0$ von 50 Hz exakt eine Phasendrehung von $-315°$ hervorrufenden Allpasses F2 und schliesslich die Funktion $\Delta\varphi = (\varphi_2 - \varphi_1) - 90°$, die die Frequenzabhängigkeit des auftretenden Winkelfehlers für die erfindungsgemässe Einrichtung angibt, dargestellt. Die Phasendrehung um $-315°$ entspricht im Ergebnis einer Phasendrehung von $+45°$. Es ergibt sich, dass selbst bei einer Frequenzänderung von 5%, d.h. im Frequenzbereich zwischen 47,5 und 52,5 Hz, der maximale Winkelfehler 2 Minuten nicht übersteigt. Das heisst, dass selbst bei erheblichen Änderungen der Netzfrequenz nahezu kein frequenzabhängiger Phasen- oder Winkelfehler mehr auftritt.

**Patentansprüche**

1. Elektronische Einrichtung zur Erfassung der Blindleistung, bestehend aus zwei zum Anschluss an ein elektrisches Netz vorgesehenen Wandlern, die ausgangsseitig dem Netzstrom bzw. der Netzspannung proportionale Messspannungen liefern, aus einem Multiplizierglied (M) mit zwei Eingängen zur Verarbeitung der beiden Messspannungen, das ausgangsseitig ein blindleistungsproportionales Signal liefert, wobei beiden Eingängen des Multiplizierglieds je ein Phasendrehglied vorgeschaltet ist, und wobei bei der Nennfrequenz $f_0$ des Netzes das erste Phasendrehglied (F2) eine Phasendrehung von $+45°$ und das zweite (F1) eine Phasendrehung von $-45°$ erzeugt, dadurch gekennzeichnet, dass jedes Phasendrehglied (F1, F2) als Allpass ausgeführt ist und dass das erste Phasendrehglied (F2) eine Übertragungsfunktion

$$-\frac{1 - jfk1}{1 + jfk1}$$

und das zweite Phasendrehglied (F1) eine Übertragungsfunktion

$$\frac{1 - jfk2}{1 + jfk2}$$

aufweist, wobei k1 und k2 jeweils von den Phasendrehgliedern (F1, F2) abhängige Konstanten sind und f die Netzfrequenz ist.

2. Einrichtung nach Anspruch 1, dadurch gekennzeichnet, dass die Eingangsklemme (e1) des zweiten Phasendrehgliedes (F1) über einen Widerstand (1) mit dem invertierenden Eingang eines Operationsverstärkers (2) verbunden ist, dessen an die Ausgangsklemme (a1) angeschlossener Ausgang über einen Widerstand (3) gleicher Grösse ebenfalls mit dem invertierenden Eingang verbunden ist, dass die Eingangsklemme (e1) ferner über einen weiteren Widerstand (4) an den nichtinvertierenden Eingang des Operationsverstärkers (2) angeschlossen ist, der zugleich über einen Kondensator (5) mit einem Bezugspotential verbunden ist, wobei für den Widerstandswert R des weiteren Widerstandes (4) und die Kapazität C des Kondensators (5) die Beziehung $\varphi_1 = -2 \cdot \arctan (2\,\pi\,f_0 CR)$ gilt.

3. Einrichtung nach Anspruch 1 oder 2, dadurch gekennzeichnet, dass die Eingangsklemme (e2) des ersten Phasendrehgliedes (F2) über einen Widerstand (6) mit dem invertierenden Eingang eines Operationsverstärkers (7) verbunden ist, dessen an die Ausgangsklemme (a2) angeschlossener Ausgang über einen Widerstand (8) gleicher Grösse ebenfalls mit dem invertierenden Eingang verbunden ist, dass die Eingangsklemme (e2) ferner über einen Kondensator (9) an den invertierenden Eingang des Operationsverstärkers (7) angeschlossen ist, der zugleich über einen weiteren Widerstand (10) mit einem Bezugspotential verbunden ist, wobei für den Widerstandswert R des weiteren Widerstandes (10) und die Kapazität C des Kondensators (9) die Beziehung $\varphi_2 = 2 \cdot \arctan 1/(2\,\pi\,f_0 CR)$ gilt.

4. Verwendung der Einrichtung nach einem der Ansprüche 1 bis 3 als Komponente eines Blindverbrauchszählers, wobei das ausgangsseitige blindleistungsproportionale Signal (u1) des Multipliziergliedes (M) über einen Quantisierer (Q) einem integrierenden Zählwerk mit Anzeige (A) zugeführt ist.

5. Verwendung der Einrichtung nach einem der Ansprüche 1 bis 3 zur Erfassung der Blindleistung in einem Drehstromsystem, wobei jeder Phase (R, S, T) des Drehstromsystems eine solche Einrichtung (BR, BS, BT) zugeordnet ist und die ausgangsseitigen blindleistungsproportionalen Signale (u1, u2, u3) der Multiplizierglieder (M, M', M'') in einem Summierglied (S) addiert sind.

6. Verwendung der Einrichtung nach einem der Ansprüche 1 bis 3 als Komponente eines Drehstrom-Blindverbrauchszählers, wobei jeder Phase (R, S, T) des Drehstromsystems eine solche Einrichtung (BR, BS, BT) zugeordnet ist und die ausgangsseitigen blindleistungsproportionalen Signale (u1, u2, u3) der Multiplizierglieder (M, M', M'') in einem Summierglied (S) addiert sind und das Ausgangssignal (u_L) des Summiergliedes (S) über einen Quantisierer (Q) einem integrierenden Zählwerk mit Anzeige (A) zugeführt ist.

**Claims**

1. An electronic device for detecting reactive power, consisting of two transducers provided for connection to an electrical network and which supply at their outputs measurement voltages proportional to the mains current and to the mains voltage. further consisting of a multiplier (M) which has two inputs for the processing of the two measurement voltages, and which at its output supplies a signal proportional to the reactive power, where the two inputs of the multiplier are each preceded by a phase rotation element and where, at the nominal frequency $f_0$ of the mains. the first phase rotation element (F2) produces a phase rotation of $+45°$ and the second phase rotation element (F1) produces a phase rotation of $-45°$, characterised in that each phase rotation element (F1, F2) is designed as an allpass filter, and that the first phase rotation element (F2) has a transfer function

$$\frac{1 - jfk1}{1 + jfk1}$$

and the second phase rotation element (F) has a transfer function

$$\frac{1 - jfk2}{1 + jfk2}$$

where k1 and k2 are each constants which are dependent upon the phase rotation elements (F1, F2) and f is the mains frequency.

2. A device as claimed in Claim 1, characterised in that the input terminal (e1) of the second phase rotation element (F1) is connected via a resistor (1) to the inverting input of an operational amplifier (2) whose output, connected to the output terminal (a1), is connected via a resistor (3) of equal value to the inverting input, that the input terminal (e1) is connected via a further resistor (4) to the noninverting input of the operational amplifier (2) which is simultaneously connected via a capacitor (5) to a reference potential, where the resistance value R of the further resistor (4) and the capacitance C of the capacitor (5) are governed by the equation: $\varphi_1 = -2 \cdot \arctan (2\,\pi\,f_0 CR)$.

3. A device as claimed in Claim 1 or 2, characterised in that the input terminal (e2) of the first phase rotation element (F2) is connected via a resistor (6) to the inverting input of an operational amplifier (7) whose output, connected to the output terminal (a2) and to the inverting input via a resistor (8) of equal value, that the input terminal (e2) is also connected via a capacitor (9) to the inverting input of the operational amplifier (7), which is simultaneously connected via a further resistor (10) to a reference potential, where the resistance value R of the further resistor (10) and the capacitance C of the capacitor (9) are governed by the equation: $\varphi_2 = 2 \cdot \arctan 1/(2\,\pi\,f_0 CR)$.

4. Use of the device as claimed in one of the Claims 1 to 3 as a component of a var-hour meter, where the output signal (u1) of the multiplier (M) – which is proportional to the reactive power – is fed via a quantiser (Q) to an integrating counter having a display (A).

5. Use of the device as claimed in one of the Claims 1 to 3 to detect the reactive power in a three-phase system, where each phase (R, S, T) of the three-phase system is assigned a device of this kind (BR, BS, BT), and where the output signals (u1, u2, u3) of the multipliers (M, M', M'') which are proportional to the reactive power, are added in an adder (S).

6. Use of the device as claimed in one of the Claimes 1 to 3 as a component of a three-phase var-hour meter, where each phase (R, S, T) of the three-phase system is assigned a device of this kind (BR, BS, BT), and the output signals (u1, u2, u3), of the multipliers (M, M', M'') which are proportional to the reactive power, are added in an adder (S), and the output signal (u_L) of the adder (S) is fed via a quantiser (Q) to an integrating counter having a display (A).

## Revendications

1. Dispositif électronique pour déterminer la puissance réactive, comprenant deux transformateurs destinés à être raccordés à un réseau électrique, qui délivrent à leurs sorties des tensions de mesure proportionnelles au courant de réseau respectivement à la tension de réseau, un élément de multiplication (M) à deux entrées pour le traitement des deux tensions de mesure, qui délivre à sa sortie un signal proportionnel à la puissance réactive, dans lequel chacune des deux entrées de l'élément de multiplication est précédée d'un élément de rotation de phase et dans lequel, à la fréquence nominale $f_0$ du réseau, le premier élément de rotation de phase (F2) produit une rotation de phase de $+45°$ et le second (F1) une rotation de phase de $-45°$, caractérisé en ce que chaque élément de rotation de phase (F1, F2) est réalisé comme un passe-tout et que le premier élément de rotation de phase (F2) présente la fonction de transfert

$$-\frac{1 - jfk1}{1 + jfk1}$$

et le second élément de rotation de phase (F1) présente la fonction de transfert

$$\frac{1 - jfk2}{1 + jfk2}$$

où k1 et k2 sont des constantes dépendantes respectivement des éléments de rotation de phase (F1, F2) et f est la fréquence du réseau.

2. Dispositif selon la revendication 1, caractérisé en ce que la borne d'entrée (e1) du second élément de rotation de phase (F1) est connecté à travers une résistance (1) à l'entrée inverseuse d'un amplificateur opérationnel (2) dont la sortie, connectée à la borne de sortie (a1), est également connectée à travers une résistance (3) de même grandeur à l'entrée inverseuse, que la borne d'entrée (e1) est reliée en outre à travers une résistance supplémentaire (4) à l'entrée directe de l'amplificateur (2), laquelle est en même temps portée à travers un condensateur (5) à un potentiel de référence, la valeur de résistance R de la résistance supplémentaire (4) et la capacité C du condensateur (5) étant définies par la relation $\varphi_1 = -2 \cdot \text{arctg} (2 \pi f_0 CR)$.

3. Dispositif selon la revendication 1 ou 2, caractérisé en ce que la borne d'entrée (e2) du premier élément de rotation de phase (F2) est connectée à travers une résistance (6) à l'entrée inverseuse d'un amplificateur opérationnel (7) dont la sortie, connectée à la borne de sortie (a2), est également connectée à travers une résistance (8) de même grandeur à l'entrée inverseuse, que la borne d'entrée (e2) est reliée en outre à travers un condensateur (9) à l'entrée inverseuse de l'amplificateur opérationnel (7), laquelle est portée en même temps à travers une résistance supplémentaire (10) à un potentiel de référence, la valeur de résistance R de la résistance supplémentaire (10) et la capacité C du condensateur (9) étant définies par la relation $\varphi_2 = 2 \cdot \text{arctg} \, 1/(2 \pi f_0 CR)$.

4. Utilisation du dispositif selon une des revendications 1 à 3 comme constituant d'un compteur d'énergie réactive, dans laquelle le signal (u1) proportionnel à la puissance réactive obtenu à la sortie de l'élément de multiplication (M) est appliqué à travers un condensateur (Q) à un mécanisme compteur intégrateur avec affichage (A).

5. Utilisation du dispositif selon une des revendications 1 à 3 pour la détermination de la puissance réactive dans un système triphasé, dans laquelle un tel dispositif (BR, BS, BT) est coordonné à chacune des phases (R, S, T) du système triphasé et les signaux (u1, u2, u3) proportionnels à la puissance réactive obtenus à la sortie des éléments de multiplication (M, M', M'') sont additionnés dans un élément de totalisation (S).

6. Utilisation du dispositif selon une des revendications 1 à 3 comme constituant d'un compteur d'énergie réactive triphasé, dans laquelle un tel dispositif (BR, BS, BT) est coordonné à chacune des phases (R, S, T) du système triphasé et les signaux (u1, u2, u3) proportionnels à la puissance réactive obtenus à la sortie des éléments de multiplication (M, M', M'') sont additionnés dans un élément de totalisation (S) et le signal de sortie (u_L) de l'élément de totalisation (S) est appliqué à travers un quantificateur (Q) à un mécanisme compteur intégrateur avec affichage (A).

FIG 1

FIG 2

FIG 3

FIG 4